# EUROPÄISCHE PATENTSCHRIFT

(11) **EP 1 138 182 B1**
(45) Veröffentlichungstag und Bekanntmachung des Hinweises auf die Patenterteilung: **13.10.2004**
(21) Anmeldenummer: 98961156.1
(22) Anmeldetag: 09.11.1998
(51) Int. Cl.: H05K 7/14

(54) **BAUGRUPPENTRÄGER**
MODULE SUPPORT
SUPPORT DE COMPOSANT

(43) Veröffentlichungstag der Anmeldung: 04.10.2001
(73) Patentinhaber: Rittal-Werk Rudolf Loh GmbH & Co. KG, 35745 Herborn (DE)
(72) Erfinder: KURIMSKI, Mike, Springfield, OH 45502 (US); WALTZ, Eike, Aptos, CA 95503 (US)
(74) Vertreter: Fleck, Hermann-Josef, Dr.-Ing.
(86) Internationale Anmeldenummer: PCT/EP1998/007125
(87) Internationale Veröffentlichungsnummer: WO 2000/028800

(56) Entgegenhaltungen:
- DE-A- 3 837 029

## Beschreibung

Die Erfindung betrifft einen Baugruppenträger mit zwei zueinander parallelen Querstreben, die mittels Führungsschiene miteinander verbunden sind, wobei die Führungsschienen mit einer Führungsaufnahme versehen sind, in denen Leiterplatten in Führungsschienen-Längsrichtung verschiebbar sind, wobei seitlich der Führungsschiene eine oder mehrere Luftführungen angeordnet sind, und wo-bei die Luftführung einer nicht mit einer Leiterplatte belegten Führungsschiene mittels einer Abdeckung überdeckbar ist.

Ein solcher Baugruppenträger ist aus der DE 38 37 029 C2 bekannt. Bei diesen Baugruppenträgern sind die Abdeckungen haubenartig ausgebildet. Sie weisen einen Deckabschnitt auf, an den eine Führungsleiste angebracht ist. Die Führungsleiste greift in die Führungsaufnahme der Führungsschiene ein.

Desweiteren trägt der Deckabschnitt ein vertikales Haltestück, das sich bis hin zu den Querstreben erstreckt. In die Querstreben sind Reihen von Befestigungsaufnahmen eingebracht, wobei die Befestigungsaufnahmen zueinander im Teilungsraster beabstandet sind. Das Haltestück der Abdeckung weist Befestigungsansätze auf, die in die Befestigungsaufnahmen der Querstrebe einsetzbar sind. Vor allem bei beengten Platzverhältnissen im Baugruppenträger ist die Anbringung der Abdeckungen an den Querstreben schwierig. Zur Fixierung der Abdeckungen müssen die Befestigungsansätze der Haltestücke sowohl in der vorderseitigen, als auch in der rückseitigen Querstrebe festgelegt werden. Vor allem das Einsetzen des hinteren Befestigungsansatzes in die zugehörige Befestigungsaufnahme bereitet dann Schwierigkeiten.

Es ist Aufgabe der Erfindung, einen Baugruppenträger der eingangs erwähnten Art zu schaffen, bei dem eine einfache Anbringung der Abdeckung an der Führungsschiene möglich ist.

Diese Aufgabe wird dadurch gelöst, dass die Führungsschiene mittels Rastverbindungen mit der Abdeckung zu einer vormontierten Einheit verbindbar ist.

Mit dieser Ausgestaltung ist es möglich, die Abdeckung zusammen mit der Führungsschiene in einem Arbeitsschritt zu positionieren und zu befestigen. Gleichwohl ist die Abdeckung im Bedarfsfall einfach von der Führungsschiene zu lö-sen, wozu die Rastverbindung aufgehoben werden muss.

Nach einer bevorzugten Ausgestaltungsvariante der Erfindung ist vorgesehen, dass die Führungssschiene an den Enden der Führungsaufnahme mittels zweier Ansätze in Längsrichtung der Querstreben verbreitert ist, dass die Führungsaufnahme und die Ansätze die Luftführung seitlich begrenzen, und dass die Abdeckung eine Platte aufweist, die die Luftführung überdeckt. Um zu verhindern, dass bei aufgesetzter Abdeckung unbeabsichtigt eine Leiterplatte in die Führungsaufnahme eingeschoben wird, kann vorgesehen sein, dass die Abdeckung einen oder zwei Vorsprünge aufweist, die die Enden der Führungsaufnahme übergreifen.

Damit der verfügbare Innenraum im Baugruppenträger mittels der Abdeckung nicht eingeengt wird, ist nach einer möglichen Erfindungsvariante vorgesehen, dass die Abdeckung einen Steg aufweist, der seitlich an die Führungsaufnahme angelegt ist, und dessen Bauhöhe die Bauhöhe der Führungsaufnahme nicht übersteigt.

Die Ausgestaltung der Rastverbindung kann derart sein, dass die Abdeckung zwei angeformte, einander zugewandte Rastelemente aufweist, und dass die Führungsschiene mit zwei als Luftführung dienenden Durchbrüchen versehen ist, in die die Rastelemente rastend eingreifen.

Damit die Abdeckung schnell und einfach von der Führungsschiene lösbar ist, kann die Abdeckung mit einer Werkzeugaufnahme und/oder eine Handhabe versehen sein.

Bevorzugterweise ist vorgesehen, dass die in Richtung der Querstreben verlaufende Breite der Abdeckung gleich oder kleiner als die Breite der Führungsschiene ist.

Zur Gewährleistung einer einfachen und passgenauen Montage der Abdeckung an der Führungsschiene ist vorgesehen, dass die Abdeckung Führungsansätze aufweist, die die Abdeckung vor dem Rasteingriff der Rastverbindung an der Führungsschiene ausrichten.

Die Erfindung wird im folgenden anhand eines in den Zeichnungen dargestellten Ausführungsbeispiels näher erläutert. Es zeigen:
- Fig. 1: in perspektivischer Darstellung zwei Querstreben eines Baugruppenträgers sowie eine Führungsschiene und eine Abdeckung,
- Fig. 2: in perspektivischer Teildarstellung die auf der Führungsschiene montierte Abdeckung und
- Fig. 3: die in Fig. 2 dargestellte Baueinheit, ergänzt um die Darstellung eines Werkzeuges.

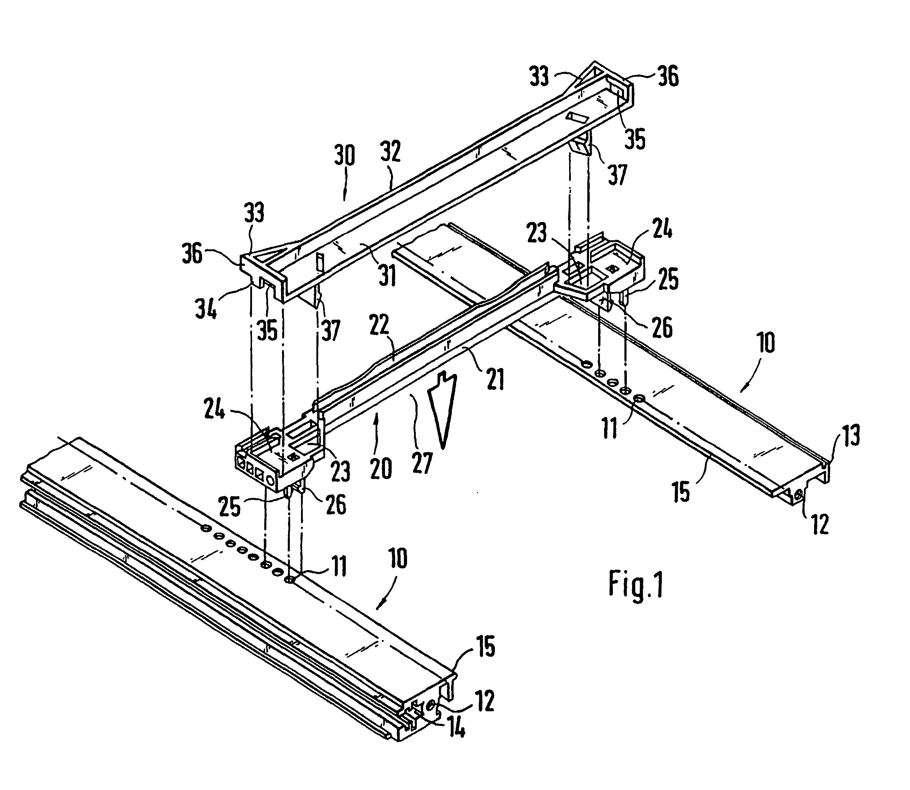

In Fig. 1 sind zwei Querstreben 10 eines Baugruppenträgers dargestellt. Diese sind als Strangpreßprofile ausgebildet und können von einem Profilhalbzeug abgelängt werden. Die Querstreben 10 weisen jeweils einen in Profillängsrichtung verlaufenden Schraubkanal 12 auf. Die rückseitige Querstrebe 10 besitzt eine rückwärtige Halterung 10, an der Kunststoffprofile befestigt werden können. Diese Kunststoffprofile dienen zur isolierten Anbringung von rückwärtigen Plattenelementen. Die frontseitige Querstrebe 10 ist mit einer hinterschnittenen Nut 14 versehen, an der Anbauten fixiert werden können. Die beiden Querstreben 10 sind jeweils mit einer Rastkante 15 versehen, die dem Innenraum des Baugruppenträgers zugewandt sind. Im Bereich der Rastkanten 15 tragen die Querstreben 10 Reihen von Befestigungsaufnahmen 11, wobei die Befestigungsaufnahmen zueinander im Teilungsraster beabstandet angeordnet sind. Die Reihen von Befestigungsaufnahmen 11 verlaufen in Längsrichtung der Querstreben 10.

An den Befestigungsaufnahmen 11 können Führungsschienen 20 befestigt werden. Die Führungsschienen 20 besitzen einen Tragabschnitt 21, der sich in Richtung der Tiefe des Baugruppenträgers erstreckt. Der Tragabschnitt 21 weist eine Führungsaufnahme 22 auf. Diese ist im Querschnitt U-förmig ausgebildet und dient zur Aufnahme von Leiterplatten. An den Enden des Tragabschnittes 21 sind Ansätze 24 angeordnet. Mittels dieser Ansätze 24 ist der Tragabschnitt 21 in Richtung der Längserstreckung der Querstreben 10 verbreitert. An die Ansätze 24 sind Zapfen 25 und Rastansätze 26 angeformt. Die Zapfen 25 und die Rastansätze 26 stehen in Richtung auf die Querstreben 10 vor. Pro Ansatz 24 sind zwei Zapfen 25 und ein Rastansatz 26 vorgesehen. Die Zapfen 25 werden zur Montage der Führungsschiene 20 an den Querstreben 10 in die Befestigungsaufnahmen 11 eingesetzt. Im eingesetzten Zustand sind die Rastansätze 26 hinter den Rastkanten 15 der Querstreben 10 verschnappt.

Die Ansätze 24 und der Tragabschnitt 21 bzw. die Führungsaufnahme 22 begrenzen eine Luftführung 27. Weiterhin sind in den Ansätzen 24 Durchbrüche vorhanden, die ebenfalls zur Luftführung genutzt werden können. Diese Luftführungen werden auch als Rastaufnahmen zur Fixierung einer Abdeckung 30 verwendet. Die Luftführungen 27 (und die Rastaufnahmen 23) werden verwendet, um der Leiterkarte, die in die Führungsaufnahme 22 eingesetzt ist, kontinuierlich Luft zuzuführen. Für den Fall, dass in die Führungsaufnahme 22 keine Leiterkarte eingesetzt ist, können die Luftführungen 27 (23) mittels der Abdeckung 30 überdeckt werden.

Die Abdeckung 30 weist eine horizontale Platte 31 auf, an die sich ein vertikaler Steg 32 anschließt. An den beiden längsseitigen Enden weist die Platte 31 vertikale Abschlußwände 36 auf. Die Abschlußwände 36 erstrecken sich in horizontaler Richtung über den Steg 32 hinaus und bilden so seitliche Vorsprünge 33. Im Bereich der Platte 31 sind die Abschlußwände 36 mit Werkzeugaufnahmen 35 versehen. Die Werkzeugaufnahmen 35 sind als Durchbruch ausgebildet. Zwischen den Werkzeugaufnahmen 35 und den Vorsprüngen 33 sind Führungsansätze 34 angeordnet.

An der Unterseite der Platte 31 sind zwei Rastelemente 37 einstückig an die Abdeckung 30 angeformt. Die Rastelemente 37 weisen einander zugekehrte Rastnasen auf.

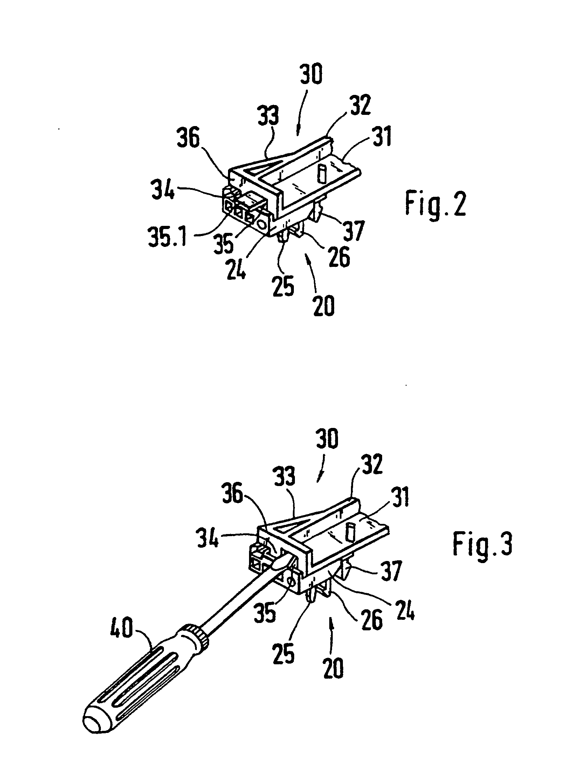

Zur Befestigung der Abdeckung 30 an der Führungsschiene 20 werden die Rastelemente 37 in die Rastaufnahmen 23 eingesetzt. Hierbei wird die Rastnase der Rastelemente 37 am Rand der Rastaufnahme 23 ausgelenkt, bis sie diesen hinterschnappen. Beim Einsetzen der Rastelemente 37 und vor dem Rasteingriff richten sich die Führungsansätze 34 seitlich an den Führungsaufnahmen 22 aus, wie dies die Fig. 2 und 3 erkennen lassen. Infolge dieser Ausrichtung wird eine paßgenaue Montage der Abdeckung 30 einfach möglich. Im montierten Zustand liegt der Steg 32 der Abdeckung 30 seitlich an der Führungsaufnahme 22 an. Die Platte 31 überdeckt die Luftführung 27 bzw. die Rastaufnahme 23.

Die Fig. 2 läßt erkennen, dass die Breite der Abdeckung 30 der Breite der Führungsschiene 20 entspricht. Die Abdeckung 30 kann zusammen mit der Führungsschiene 20 zu einer Einheit vormoniert werden, die als solche in dem Baugruppenträger montiert werden kann. Für den Fall, dass in die Führungsschiene 20 eine Leiterkarte eingesetzt werden soll, läßt sich die Abdeckung 30 einfach entfernen. In den Fig. 2 und 3 sind hierzu zwei Varianten dargestellt, die einen einfachen Abbau der Abdeckung 30 zulassen. Gemäß der Fig. 2 ist hierzu im Bereich der Werkzeugaufnahme 35 eine Handhabe 35.1 angeformt. Diese Handhabe 35.1 ist als Lappen ausgebildet, der rechtwinklig von der Abschlußwand 36 vorsteht. Die Handhabe 35.1 kann mit einem Finger untergriffen werden und anschließend läßt sich die Abdeckung 30 anheben, wobei die Rastelemente 37 außer Eingriff mit den Rastaufnahmen 23 gelangen. Ein Lösen der Abdeckung 30 ist auch mit einem Werkzeug möglich. Dieses kann in die Werkzeugaufnahme 35 eingeschoben werden. Die Abdeckung 30 läßt sich dann aushebeln, wobei sich das Werkzeug an der Führungsschiene frontseitig abstützt. Bei der Ausgestaltungsvariante gemäß Fig. 3 kann als Werkzeug ein Schraubendreher 40 eingesetzt werden, der in die Werkzeugaufnahme 35 eingesteckt ist. Mit dem Schraubendreher 40 kann die Abdeckung 30 ausgehebelt werden.

## Patentansprüche

1. Baugruppenträger mit zwei zueinander parallelen Querstreben, die mittels Führungsschiene miteinander verbunden sind, wobei die Führungsschienen mit einer Führungsaufnahme versehen sind, in denen Leiterplatten in Führungsschienen-Längsrichtung verschiebbar sind, wobei seitlich der Führungsschiene eine oder mehrere Luftführungen angeordnet sind, und wobei die Luftführung einer nicht mit einer Leiterplatte belegten Führungsschiene mittels einer Abdeckung überdeckbar ist,
**dadurch gekennzeichnet,**
**dass** die Führungsschiene (20) mittels Rastverbindungen mit der Abdeckung (30) zu einer vormontierten Einheit verbindbar ist.

2. Baugruppenträger nach Anspruch 1,
**dadurch gekennzeichnet,**
**dass** die Führungsschiene (20) an den Enden der Führungsaufnahme (22) mittels zweier Ansätze (24) in Längsrichtung der Querstreben (10) verbreitert ist,
**dass** die Führungsaufnahme (22) und die Ansätze (24) die Luftführung (27) seitlich begrenzen, und
**dass** die Abdeckung eine Platte aufweist, die die Luftführung (27) überdeckt.

3. Baugruppenträger nach Anspruch 1 oder 2,
**dadurch gekennzeichnet,**
**dass** die Abdeckung (30) einen oder zwei Vorsprünge (33) aufweist, die die Enden der Führungsaufnahme (22) übergreifen.

4. Baugruppenträger nach einem der Ansprüche 1 bis 3,
**dadurch gekennzeichnet,**
**dass** die Abdeckung (30) einen Steg (32) aufweist, der seitlich an die Führungsaufnahme (22) angelegt ist, und dessen Bauhöhe die Bauhöhe der Führungsaufnahme (22) nicht übersteigt.

5. Baugruppenträger nach einem der Ansprüche 1 bis 4,
**dadurch gekennzeichnet,**
**dass** die Abdeckung (30) zwei angeformte, einander zugewandte Rastelemente (37) aufweist, und
**dass** die Führungsschiene (20) mit zwei als Luftführung dienenden Durchbrüchen (23) versehen ist, in die die Rastelemente (37) rastend eingreifen.

6. Baugruppenträger nach einem der Ansprüche 1 bis 5,
**dadurch gekennzeichnet,**
**dass** die Abdeckung (30) eine Werkzeugaufnahme (35) und/oder eine Handhabe (35.1) aufweist, mittels der die Rastverbindung zwischen der Abdeckung (30) und der Führungsschiene (30) aufhebbar ist.

7. Baugruppenträger nach einem der Ansprüche 1 bis 5,
**dadurch gekennzeichnet,**
**dass** die Richtung der Querstreben (10) verlaufende Breite der Abdeckung (30) gleich oder kleiner als die Breite der Führungsschiene (20) ist.

8. Baugruppenträger nach einem der Ansprüche 1 bis 7,
**dadurch gekennzeichnet,**
**dass** die Abdeckung (30) Führungsansätze (34) aufweist, die die Abdeckung (30) vor dem Rasteingriff der Rastverbindung an der Führungsschiene (20) ausrichten.

9. Baugruppenträger nach einem der Ansprüche 1 bis 8,
**dadurch gekennzeichnet,**
**dass** die Abdeckung (30) als Kunststoff-Spritzgußteil oder -Preßteil ausgebildet ist.

## Claims

1. Mounting rack having two parallel transverse struts which are connected to one another by means of guide rails, the guide rails being provided with a guide mount in which printed circuit boards can be displaced in the longitudinal direction of the guide rails, one or more air guides being arranged to the side of the guide rail, and it being possible for the air guide of a guide which is not occupied by a printed circuit board to be covered over by means of a covering, **characterized in that** the guide rail (20) can be connected to the covering (30), by means of latching connections, to form a preassembled unit.

2. Mounting rack according to Claim 1, **characterized in that** the guide rail (20) is widened at the ends of the guide mount (22), in the longitudinal direction of the transverse struts (10), by means of two extensions (24), **in that** the guide mount (22) and the extensions (24) bound the air guide (27) laterally, and **in that** the covering has a plate which covers over the air guide (27).

3. Mounting rack according to Claim 1 or 2, **characterized in that** the covering (30) has one or two protrusions (33) which engage over the ends of the guide mount (22).

4. Mounting rack according to one of Claims 1 to 3, **characterized in that** the covering (30) has a crosspiece (32) which is positioned laterally against the guide mount (22) and of which the overall height does not exceed the overall height of the guide mount (22).

5. Mounting rack according to one of Claims 1 to 4, **characterized in that** the covering (30) has two integrally formed latching elements (37) directed towards one another, and **in that** the guide rail (20) is provided with two through-passages (23) which serve as an air guide and in which the latching elements (37) engage with latching action.

6. Mounting rack according to one of Claims 1 to 5, **characterized in that** the covering (30) has a tool mount (37) and/or a handle (35.1) by means of which it is possible to eliminate the latching connection between the covering (30) and the guide rail (20).

7. Mounting rack according to one of Claims 1 to 6, **characterized in that** the width of the covering (30), as seen in the direction of the transverse struts (10), is equal to or less than the width of the guide rail (20).

8. Mounting rack according to one of Claims 1 to 7, **characterized in that** the covering (30) has guide extensions (34) which align the covering (30) prior to the latching engagement of the latching connection on the guide rail (20).

9. Mounting rack according to one of Claims 1 to 8, **characterized in that** the covering (30) is designed as a plastic injection moulding or as a pressed plastic component.

## Revendications

1. Support de modules comprenant deux entretoises parallèles l'une à l'autre, qui sont connectées l'une à l'autre par le biais de rails de guidage, les rails de guidage étant pourvus d'un logement de guidage, dans lesquels des plaquettes de circuits imprimés peuvent être coulissées dans la direction longitudinale des rails de guidage, une ou plusieurs conduites d'air étant prévues latéralement aux rails de guidage, et la conduite d'air d'un rail de guidage non muni d'une plaquette de circuits imprimés pouvant être recouverte par un recouvrement,
**caractérisé en ce que**
le rail de guidage (20) peut être connecté au moyen de connexions par encliquetage au recouvrement (30) pour fournir une unité prémontée.

2. Support de modules selon la revendication 1,
**caractérisé en ce que**
le rail de guidage (20) est élargi au niveau des extrémités du logement de guidage (22) au moyen de deux pièces rapportées (24) dans la direction longitudinale des entretoises (10),
**en ce que** le logement de guidage (22) et les pièces rapportées (24) limitent latéralement la conduite d'air (27), et **en ce que** le recouvrement présente une plaque qui recouvre la conduite d'air (27).

3. Support de modules selon la revendication 1 ou 2,
**caractérisé en ce que**
le recouvrement (30) présente une ou deux saillies (33) qui viennent en prise par le dessus avec les extrémités du logement de guidage (22).

4. Support de modules selon l'une quelconque des revendications 1 à 3,
**caractérisé en ce que**
le recouvrement (30) présente une nervure (32) qui est placée latéralement sur le logement de guidage (22), et dont la hauteur de construction ne dépasse pas la hauteur de construction du logement de guidage (22).

5. Support de modules selon l'une quelconque des revendications 1 à 4,
**caractérisé en ce que**
le recouvrement (30) présente deux éléments d'encliquetage (37) moulés, tournés l'un vers l'autre, et
**en ce que** le rail de guidage (20) est pourvu de deux perçages (23) servant de conduite d'air, dans lesquels viennent en prise par encliquetage les éléments d'encliquetage (37).

6. Support de modules selon l'une quelconque des revendications 1 à 5,
**caractérisé en ce que**
le recouvrement (30) présente un logement d'outil (35) et/ou une manette (35.1) au moyen duquel/de laquelle la connexion par encliquetage entre le recouvrement (30) et le rail de guidage (20) peut être supprimée.

7. Support de modules selon l'une quelconque des revendications 1 à 6,
**caractérisé en ce que**
la largeur du recouvrement (30) dans la direction des entretoises (10) est inférieure ou égale à la largeur du rail de guidage (20).

8. Support de modules selon l'une quelconque des revendications 1 à 7,
**caractérisé en ce que**
le recouvrement (30) présente des pièces rapportées de guidage (34) qui alignent le recouvrement (30) avant l'engagement par encliquetage de la connexion par encliquetage sur le rail de guidage (20).

9. Support de modules selon l'une quelconque des revendications 1 à 8,
**caractérisé en ce que**
le recouvrement (30) est réalisé sous forme de pièce en plastique moulée par injection ou sous forme de pièce estampée en plastique.
